# EUROPEAN PATENT SPECIFICATION

(11) **EP 3 323 148 B1**
(45) Date of publication and mention of the grant of the patent: **06.11.2019**
(21) Application number: 16745810.8
(22) Date of filing: 20.06.2016
(51) Int. Cl.: H01L 31/0224

(54) **PHOTOVOLTAIC CELL OF THE MWT TYPE FOR DEDICATED CONDUCTIVE BACKSHEET**
FOTOVOLTAISCHE ZELLE VOM MWT-TYP FÜR EIGENE LEITFÄHIGE RÜCKSEITENFOLIE
CELLULE PHOTOVOLTAÏQUE DU TYPE MWT POUR FEUILLE ARRIÈRE CONDUCTRICE DÉDIÉE

(30) Priority: 13.07.2015 IT UB20152112
(43) Date of publication of application: 23.05.2018
(73) Proprietor: Vismunda S.r.l., 35137 Padova (PD) (IT)
(72) Inventor: SPOTTI, Davide, 34126 Trieste (IT)
(74) Representative: Spagnolo, Chiara
(86) International application number: PCT/IB2016/000885
(87) International publication number: WO 2017/009702

(56) References cited:
- WO-A2-2013/085387
- US-A1- 2013 112 233
- NOT PROCESSED ED - WIP-RENEWABLE ENERGIES: EU PVSEC PROCEEDINGS : 25TH EUROPEAN PHOTOVOLTAIC SOLAR ENERGY CONFERENCE AND EXHIBITION / 5TH WORLD CONFERENCE ON PHOTOVOLTAIC ENERGY CONVERSION, 6-10 SEPTEMBER 2010, VALENCIA, SPAIN, MUNICH, DE, 6 September 2010 (2010-09-06), XP040531765, ISBN: 978-3-936338-26-3

## Description

The present invention relates to a back-contact photovoltaic cell of crystalline silicon, of the type called Metal Wrap Through or MWT, for a conductive backsheet intended for its electrical contacting in photovoltaic panels. Document US2013/112233A describes a solar cell.

### Field of the invention

The invention finds particular application in the industrial photovoltaic sector with specific reference to the modern photovoltaic panels with back-contact cells. The present invention proposes a particular and advantageous configuration of a back-contact cell, for photovoltaic panels which also integrate at the back a supporting component already provided with electrical circuitry called conductive backsheet.

In principle, it is widely known that the industrial costs and the conversion efficiency of the solar cells are some of the main variables which today determine the success and widespread use of photovoltaic energy electrical generation systems. For the purpose of improving such parameters, the main companies operating in the photovoltaic sector and also some research centres for some years have been proposing innovative solutions of cells intended to reduce the cost of the energy actually produced by the installed system, where such energy is related to the manufacturing costs of the cell and of the modules and also to the costs of assembly and connection of the modules, according to the known parameter called Levelized Cost Of Energy or LCOE. For example, some manufacturers have tried to improve the purity and the efficiency of the silicon used, others have experimented alternative semiconductor materials with respect to silicon, such as cadmium, gallium, arsenic or indium, others have developed new optical systems to be integrated on the exposed front of the cell.

Nowadays, among the most advanced and advantageous solutions there are photovoltaic cells characterised by innovative architectures such as, in particular, the back-contact cells. Such cells substantially provide that all the contacts are on the back face in such a way as to increase the actually eradiated area, that is to say, the front portions of cell shaded by the contacts or by the interconnection between one cell and the other are reduced, and also in such a way as to optimize the configuration of the modules because contacting is considerably simplified, it occurring only on the back face of the cell, and also allowing for a reduction in the empty spaces between the cells. Furthermore, such advantages provide the possibility of improving the design of the finished module.

However, it has been observed that, although such advantages are widely known, said photovoltaic panels with cells of the back-contact type are still little widespread because of many production, quality and economical difficulties. In more detail, at present the main difficulties concern the realization and the configuration of the electrical contacts; one has to think about the accuracy required in the working processes such as drilling or metallization, or about the circuital logic of the panel or also about the high automation of the production plant. It is also known that, sometimes, such solutions imply high industrial costs against a limited increase in efficiency. For these and other reasons, therefore, today most of the panels on the market still have conventional architectures, of the non-back-contact type, very similar to one another in their concept, basic components and assembly process.

Among the known types of back-junction cells one should mainly remember the variants called Emitter Wrap Through, or EWT, and the variants called Metal Wrap Through or MWT. Said EWT cells reach high efficiency, generally included between 20% and 22%, but are based on difficult photolithographic processes with high vacuum deposition and controlled atmosphere and also provide the use of lasers which are intended to make thousands of holes in each cell, thus implying extremely high production costs such as to hinder their spreading. On the other hand, it has been experimentally verified that said MWT variants are more advantageous for industrial purposes and have much lower costs, against a little lower efficiency with respect to said EWT cells but higher than conventional cells, it being between 18% and 20%; they provide a limited number of holes and employ industrial technologies substantially similar to those already widely used for cells of the conventional type with direct contacting on both faces.

In more detail, in order to describe the MWT cells to which the present invention applies, we will adopt as a reference the cells obtained from positive charge silicon, conventionally called p-type, and frontally doped with a negative layer; in this way the finished cell will have the upper face, exposed to the sun, of negative polarity N and the lower face of positive polarity P. This reference is advantageous for the descriptive purposes of the invention only since in industrial reality the MWT cells can also be obtained from negative charge silicon, conventionally called n-type, and frontally doped with a positive layer; in this way the finished cell will have inverse polarities with respect to the previous one. The present invention applies to both architectures of MWT cells, namely both p-type and n-type, but conventionally and for descriptive convenience the p-type was selected as reference. In said MWT cells energy is collected on the exposed front face, called negative side or N face, it being characterised by negative charges by means of multiple metallized ramifications which generally have a parallel or radial configuration and are called fingers; said collection fingers convey the electrons directly on the opposite face, or P face, it being positively doped as described in said reference configuration, through through-holes or vias and conductive elements of connection between fingers, which are also called connection busbars and have an increased section. Said vias are also called N electrodes or N holes, as it conventionally occurs in the present description, they being intended to collect said negative charges and convey them onto the back face in a electrically separate way from the opposite sign currents which are simultaneously generated on that face, ensuring continuity to the serial connections of each string formed by adjacent and aligned cells. For the purpose of saving on metallization as well, avoiding any short-circuits or interferences and facilitating the electrical contacting or stringing operations, said positive currents, too, are sometimes concentrated in strips, sections or points of electrical contacting; such contacting elements are thus called P electrodes, P contacts or even P points, as it conventionally occurs in the present description.

Therefore, on the back face of a MWT cell, in said reference configuration, there are multiple negative contact points, namely at the outlet of said internally metallized N through-holes, and multiple positive contacts, that is to say, said P points; generally, said N holes and said P points are aligned in parallel for machining and contacting convenience in such a way as to be able to be interconnected also by means of conventional conductive ribbons. The most widespread configurations of MWT cells have N holes arranged in an orthogonal matrix and central symmetry with 2, 3 or 4 rows of holes each, conventionally called of the 2x4, 3x3 and 4x4 type also depending on the number of holes; in particular, it is possible to consider as conventional the different arrangements in which the number of the rows of N holes corresponds to the number of the holes in each of them, that is to say, 3x3, 4x4, 5x5 or 6x6 according to said central symmetry and wherein, on the back face, the rows of the P points are spaced in parallel with respect to them also with an alternate pace in the longitudinal direction.

Therefore, it has been observed that today the assembly processes of photovoltaic panels are still little automated and include many manual operations, with a high probability of errors, reprocessing, waste with a consequent decrease in quality and reliability and with high industrial and labour costs; in particular, also in the case of panels with back-contact cells there are often long stringing operations with the welding of conductive ribbons involving, among other things, problems in the continuity and repeatability of the process and of breaking of cells, quality control and inspection of the product during the assembly process, in particular in the case of large production volumes.

To this purpose we remind that a cell configuration of the MWT type, with the N and P contacts arranged on the back face, advantageously allows to eliminate the conventional manual operations of interconnection between adjacent cells, thus increasing the level of automation in production, with greater process repeatability and quality, and also allows to use the innovative and advantageous integrated contacting systems. Particular reference is made to the known solutions of back supports, or backsheets, which also comprise the electrical interconnection means and advantageously allow to prevent the application on said cells of the single conductive ribbons; such a composite element is called a conductive backsheet. To this purpose, see the various solutions in which the electrical circuitry is made by means of a suitably machined sheet of conductive material, placed at the back of the cells and supported by the backsheet, as for example in EP2139050 (Bakker et al.), WO2012058053 (Meakin et al.) or WO2013115851 (Kian et al); furthermore, see the advantageous solution of a multilayer and multifunction backsheet, which incorporates a thin conductive layer also with the insulating and the encapsulating material, as for example in ITTV2012A000211 (Baccini et al.).

Nowadays, due to the efficiency achieved and to the high degree of assembly automation, the back-contact cells are considered more advantageous than the conventional cells in which the conductive ribbons are progressively welded on opposite faces of adjacent cells, namely by ribboning from the upper face to the lower face of adjacent and successive cells; therefore, said back-contact cells are preferable because they are stringed at the back by means of planar conductive ribbons or, preferably, directly contacted by means of an advantageous supporting backsheet already provided with the electrical circuits. Furthermore, known and extremely advantageous is the integrated solution of a conductive backsheet already comprising the dielectric mask and the lower encapsulating material in order to facilitate the automatic assembly phases and improve the quality of the product.

From a production point of view, in fact, a photovoltaic panel with a back-contact architecture associated with said conductive backsheet particularly allows to reduce or eliminate the manual operations lowering industrial costs, increasing the level of industrialization, automation and repeatability in case of large production volumes. In order to better contextualize the advantages provided by the use of said back-contact cells and also to highlight their critical points which hinder their widespread use, we will recall the production process of a photovoltaic panel with MWT cells, whose basic components are described in detail in the following starting from the back side towards the front side exposed to the sun:
- a conductive backsheet comprising an internal thin metal layer, with high conductivity, generally made by rolling with following selective removal in such a way as to make a circuit which will electrically connect in series the solar cells placed thereon and interconnected. Today the technologies suitable for making such an element are widely known and available, for example, milling, etching, shearing, lasering, selective deposition;

- photovoltaic cells of single-crystal or multi-crystal silicon, of the MWT type with the N and P contacts placed on the back face;
- a conductive material between said conductive backsheet and the back faces of the cells, in correspondence of the contacts of different electrical polarity, being for example of the type called Electronic Conductive Adhesive or ECA, or of the welding paste type or other equivalent materials; said material being generally applied by silkscreen printing or with a dispenser, with a system of the jet-dispensing type or with other equivalent laying solutions;
- two layers of encapsulating material, generally ethyl vinyl acetate, which is also known by the acronym EVA, or of the polyolefin or POE type, the back layer of which is holed in correspondence of the contacts created by said conductive material, enclosing at the front and at the back all the above-described elements;
- an insulating material which is interposed between the back side of the cells and said conductive backsheet, having openings in correspondence of the zones of contact with the back polarities of said cells;
- a flat glass, the frame and a junction box.

Among the main technical difficulties in the use of said MWT cells for the purpose of the industrial production of panels with a back-contact architecture, and particularly in case of large production volumes, there are some problems of electrical contacting both with reference to the making of the single cell and with reference to the simultaneous stringing of all the cells of the panel; among the most known problems there is, for example, the considerable precision required for through-holing and for the metallization inside these holes or the recombination of the currents between the two faces. In particular, significant difficulties of connection of the MWT cells near the corners of the panel in the case in which there is a backsheet integrating one single conductive layer have been observed, an advantageous configuration not being known to date for the contacting both of negative sign and of positive sign at the lower and upper end of each string of cells, that is to say, intended to couple with the corresponding negative and positive contacts of the end cells in such a way as to be successively connected to the currents of the close strings, and up to the junction box, without exiting from the area occupied by the cells and without adding conductive ribbons.

The main companies operating in the sector have recently proposed many advantageous configurations of front metallization for MWT cells with fingers arranged in the most varied regular or irregular configurations, for example in an orthogonal matrix or radially, in order to increase the collected energy and carry in the most effective way said negative charges on the back face, through said N holes. However, it has been observed that nowadays the technical optimization of a MWT cell, in terms of actual conversion efficiency, as well as its widespread use, are widely related to the configuration of the electrical contacts and particularly to the number, to the arrangement and to the alignment of said N holes and P points, a given design of the conductive backsheet and of the assembly process of the corresponding module being associated with said configuration of the contacts on the cell as well. To this purpose, it has been experimentally verified that, by modifying the configuration of the contacts in the back face of the cell, one can obtain remarkable improvements in terms of production automation, control and repeatability, also with greater advantages in terms of actual efficiency with respect to said optimizations of the front fingers and, therefore, in conclusion, in terms of overall costs.

Therefore, the present invention aims at optimizing said configuration of the contacts in a MWT cell, with particular reference to the N holes and to the P points in the back face of the cell, in such a way as to improve quality and efficiency, facilitate the production phases of automatic assembly of the panel allowing the use of a dedicated conductive backsheet, considerably reduce industrial costs and thus reduce said LCOE of the associated photovoltaic energy.

### Prior art

For the purpose of determining the prior art related to the proposed solution a conventional check was made, searching public archives, which has led to find some prior art documents, among which:
D1: US8575475 (Sakamoto et al.)
D2: CN103094369 (Li Jifei et al.)
D3: CN102956746 (Wang Shubo)
D4: CN203674221 (Xu Juan et al.)
D5: WO2010097268 (Krokoszinski)
D6: WO2015003600 (Lu Zhonglin et al.)
D7: US2014318614 (Von Campe et al.)

D1 and D2 propose a particular arrangement of the N and P contacts on the back face of a MWT cell, being continuously aligned and alternate with the adjacent cells in such a way as to enable contacting by means of parallel ribbons, facilitating stringing.

D3 describes an improved configuration of a MWT cell with a regular matrix of the type with 3x3 N holes, wherein the surface is divided into 9 square portions where on the centre of each portion there is a N hole in such a way as to improve efficiency reducing losses due to non-uniform diffusion or to impurities in the material; on the front face the radially arranged fingers are limited to each portion with a N hole and likewise on the back face metallization printing forms a P electrode of large dimensions and easy contacting which also delimits an insulated path for the contacting from the N hole to the contiguous P electrode.

D4 proposes an improved configuration of a MWT cell with a regular matrix with the conventional parallel fingers and with 4 orthogonal busbars, wherein on each of them there are 4 N holes having the contacting of rhomboidal shape in such a way as to reduce the area occupied by the metallization and increase the receiving area.

D5 describes a MWT cell having the N holes aligned on 5, 7 or 9 rows and the P points which are alternate with respect to them with a regular pace in such a way as to allow the contacting on the back by means of multiple conductive ribbons arranged parallel at a constant pace and interconnected at the head like a comb, completing the circuitry on the adjacent cell with the rows of opposite sign.

D6 proposes an improved configuration of a MWT cell with N holes arranged in matrix of the K x K type, K being an integer greater than or equal to 5 or with at least 5 rows of N holes and a corresponding number of holes in each of them, and with 4x4 P points on the back face arranged in a matrix, in such a way that the front metallization allows to limit shielding and the consumption of silver paste.

D7 describes a photovoltaic cell of the MWT type where on the back face the N contacts are punctiform and aligned in 2 or 4 parallel rows while the P contacts are in the form of continuous strips, parallel to each other; in a particular configuration the N holes are aligned in 4 rows of 8 holes each, spaced at a constant pace by 3 strips constituting the P contacts and having a little smaller length than the total length of the cell. The electrical contacting between adjacent cells occurs planarly by means of the application of conductive ribbons in a comb arrangement alternately over said N holes of a cell and said P strips of the contiguous cell, or in an embodiment variant there is the possibility to obtain this electrical connection by means of the superimposition of a conductive sheet.

In conclusion it is reasonable to consider as known:
- a photovoltaic panel with back-contact cells planarly stringed by welding conductive ribbons;
- a photovoltaic panel with back-contact cells and a back support also comprising the electrical circuits, which is also called a conductive backsheet;
- a back-contact photovoltaic cell of the MWT type with front collection metallization made in different shapes, with parallel or radially arranged fingers, wherein the N through-holes are aligned in rows with an arrangement of the type with 3 rows with 3 holes each also called 3x3, or even of the type 4x4, 5x5, 6x6, 2x8 or 4x8, and wherein the P back contacts are aligned in parallel to said N rows, in the form of aligned points or continuous strips;
- a photovoltaic panel with MWT cells wherein the electrical contacting between adjacent cells occurs planarly on the back of the cells by means of the application of conductive ribbons in a comb arrangement or, in an embodiment variant, by means of the superimposition of a conductive sheet.

### Drawbacks

In conclusion, we have observed that the described known solutions have some drawbacks or anyway some limits.

First of all, in the known solutions as for example in D1-7, it has been observed that the configuration of the electrical contacts of the MWT cells and in particular the number and the position of said N through-holes and of said P back contacts are not optimized depending on the following technical problems, if considered simultaneously, and namely interacting with one another: a large amount of silver paste used for the metallization of the cell, limited efficiency in the passage of the electrical charges between the two opposite faces, limited automation of the production processes of the photovoltaic panel with limited productivity and repeatability, difficult circuitry between adjacent cells near the corners if in the panel one uses a modern conductive backsheet instead of the conventional conductive ribbons. As a consequence, high industrial costs for producing said MWT cells and also for assembling them in photovoltaic panels have been observed in all the known solutions.

In more detail as to the above-mentioned problems, it is well known that in the most widespread configuration of a MWT cell, that is to say, with 16 N holes arranged in a regular matrix of 4 rows with 4 holes each, a large amount of silver paste is necessary for the front metallization; in fact, it has been observed that in this type of cells the making of front busbars and fingers implies the highest production cost after the cost of the silicon related to the original wafer; it has also been observed that the solutions of the 4x4 type optimized for this purpose, as for example in D4, provide a limited reduction in metallization costs. The number, the diameter and the position of said N holes, also in relation to the number, shape and position of said P contacts, moreover, affect the correct passage of the charges frontally collected by said metallization, since phenomena of dispersions or recombinations inside the cell are frequent in the conventional solutions of MWT cells.

Furthermore, it has been observed that said configurations of the N and P contacts considerably affect the efficiency of the production processes; in fact, it has been experimentally verified that in the drilling with modern industrial lasers it is disadvantageous to exceed the number of 4 parallel rows per each cell, as for example in D5 and D6, while it has been observed that for some quality problems in metallization and for the high industrial costs it is disadvantageous to exceed the number of 6 holes per each row, as for example in D7.

Moreover, in all the known and conventional solutions of panels with MWT cells problems of correct contacting and conduction of the electrical charges on the back face of the cell have been experimentally observed in the case in which one uses a conductive backsheet instead of the conventional conductive ribbons welded between adjacent cells, generally of opposite sign and arranged alternately in a comb-like manner, the number and the position of the electrical contacts of the cell, that is to say, said N holes and P points, being extremely binding for the purpose of the circuit configuration of the whole panel. In more detail, solutions are not known of a MWT cell able to couple directly, without additional costs, with a conductive backsheet dedicated to its contacting and such as to complete the electrical paths of the panel overcoming the various problems of continuity of the connection at the ends of each string and in correspondence of the junction box; in particular, it has been observed that, due to superimpositions and/or short-circuits, the main problems occur in correspondence of the cells positioned at the corners of the panel and whenever the electrical path continues laterally, that is to say, orthogonally with respect to the previous cell; in such zones one can easily create a concentration of current with respect to the reduced section of the conductive layer which can constitute a harmful bottleneck with a significant resistive increase and a consequent yield drop and dangerous localised temperature increases. Such an optimization problem grows in proportion to the growing number of P and N points per each cell.

Therefore, considering the foregoing, although the advantages of a coupling of the MWT cell with a backsheet of the conductive type are known for the purpose of obtaining photovoltaic panels, as for example in D7, configurations are not known of MWT cells individually optimized for direct contacting by means of one single conductive layer, in such a way as to solve said problems of electrical connection of said N holes and P points in any configuration of string and/or panel and in any position of the cell on said conductive layer.

An additional problem which has been found in the conventional and known solutions concerns the low automation and repeatability in production.

Another problem consists of the high overall costs for the assembly of the panels due to the interconnection of the MWT cells by means of conventional stringing; in particular, in the cells in which the P contacts are configured as a conductive strip and not as single points, as for example in D1, D2, D3 and D7, a great waste of conductive material in the cell has been observed.

Hence the need for the companies of the sector to find solutions which are more effective with respect to the existing solutions; the aim of the present invention is also to solve the described drawbacks.

### Short description of the invention

This and other aims are achieved by the present invention according to the characteristics as in the appended claims, solving the arising problems by means of a back-contact photovoltaic cell (10) of crystalline silicon of the Metal Wrap Through or MWT type, for a dedicated conductive backsheet (20); said cell (10) having holes for the crossing of the collected electrons at the front and punctiform back contacts for the charges of opposite sign, respectively N holes (102) and P points (104), arranged according to a configuration of the contacts which is also advantageous for the purpose of automated production and for the association with a conductive backsheet (20) integrating one single conductive layer (200) intended to connect by strings the N holes and P points of all the cells, completing the electrical circuitry of the whole panel. The cell (10) comprises 24 N holes (102) and 15 P points (104), respectively aligned in 4 N rows (103) of 6 holes each and in 3 P rows (105) of 5 points each, with particular centre-to-centre distances.

### Aims

In this way by the considerable creative contribution the effect of which has allowed to reach a considerable technical progress, some aims and advantages are achieved solving the main problems pointed out.

A first aim of the invention was to optimize the configuration of the back face of a MWT cell of conventional width and particularly to optimize the number and the position of the electrical contacts, or the N through-holes and the P points, in such a way as to use the minimum amount of silver paste for the metallization of the front of the cell and also, simultaneously: enable a better passage of the electrical charges between the two opposite faces avoiding dispersions or recombinations inside the cell, enable automated production processes for large production volumes and particularly laser drilling and metallization, enable the interconnection between adjacent cells by means of a modern conductive backsheet intended for the contacting of their respective back faces.

A second aim was to obtain the best compromise between the cost of the electrodes, which grows as the holes grow, the series resistance which decreases as the electrodes grow with equal section and used materials, and the certainty of connection in case some electrodes lost the contact during the life cycle of the module. To this purpose, it has thus been observed that, with respect to the conventional 9 or 16 N holes, a solution with 24 N holes is considerably more advantageous; therefore, an aim of the invention is to optimize the configuration on the cell of said N holes and P points on the back face. It has also been observed that the known solutions providing a greater number of N electrodes, for example 36 N holes arranged according to a 6x6 configuration, are not optimal because they increase the cost of the cell too much, due to the great number of holes to be metallized, and also imply a greater risk of breaking of the cell. Such solutions, moreover, imply a longer time and a greater cost for making the corresponding conductive backsheet and also imply a great complication of the process of interconnection between adjacent cells, with a larger amount of conductive adhesive and a high risk of problems in the circulation of the currents, sometimes called bottlenecks. It has also been observed that, for the purposes of the invention, the specific shape of said front collection fingers is not considered, being for example parallel or radially arranged, but, on the other hand, one considers the particular configuration of said N holes of passage of the electrons on the opposite face, in relation to the particular configuration of said P points.

A third aim was to optimize the configuration of the back contacts of the cell depending on the use with a dedicated conductive backsheet, for the purpose of the direct interconnection of the cells to automatically form the photovoltaic panel by superimposition and superficial gluing by means of a conductive adhesive and without manual interventions, not even in the interconnection of cells in correspondence of the corner of the photovoltaic panel. The use of a conductive backsheet instead of the conventional welded strings provides significant advantages, already known in patent literature, both in terms of simplification in the configuration of the photovoltaic module and in terms of the use of automatic machines for the assembly of the module; a conductive backsheet, in particular, allows to significantly reduce the cost of the photovoltaic panel also increasing process repeatability and quality. The present invention makes the use of said conductive backsheet for the interconnection of said MWT cells even more advantageous, further reducing the final cost of a photovoltaic panel and without increasing the cost of said backsheet.

A further aim was to not increase the time and the industrial cost for the different working processes necessary for the production of the cell and of the panel, with respect to the most widespread conventional solutions. In fact, it has been observed that, with respect to the conventional solution with a matrix with 16 N holes, or 4 parallel rows of 4 holes each, the innovative proposed solution with 24 N holes arranged on 4 parallel rows of 6 holes each, suitably positioned, does not lead to any increase in the time required for processing the cell or for processing the conductive layer in the case of a modern multilayer conductive backsheet, of the integrated type; to this purpose, we remind that said conductive backsheet is to date the most expensive component of the module, after the cells. It has also been observed that the known solutions with a symmetrical matrix comprising a greater number of rows, such as the arrangement called 5x5 or 6x6, imply greater costs for processing the cell and the conductive backsheet with respect to the proposed solution. As already known from patent and scientific literature, in fact, the mechanical milling of the conductive backsheet is one of the technologies which allow to obtain the lowest cost per square metre in the industrial production of this essential component for the technical evolution of photovoltaic panels; the configuration proposed by the invention, conventionally called 6x4, provides 6 N holes milled in line on 4 columns and implies a smaller milling path and therefore involves a shorter production time and a lower cost with respect to the known 5x5 configuration, which requires about 20% time more because of the 5 columns, or even with respect to the known 6x6 configuration, which requires about 50% time more because of the 6 columns.

Another aim was to optimize the arrangement of said N holes and P contact points in such a way as to reduce the time of automatic laying of the drops of conductive adhesive, which is also known by the acronym ECA, between said contacts and said conductive backsheet.

Another aim was to configure said N and P contacts in such a way as to optimize the conductive sections of said backsheet, in particular reducing the dimensions of the sections which carry the currents without experiencing the known problem of undersizing which causes heating, deformations or localised losses of the contact, as sometimes occurs in correspondence of the corners and at the end of the strings.

Another aim, deriving from the above-mentioned advantages, was to enable the highly automated making of photovoltaic panels with a back-contact architecture, in such a way as to improve repeatability, increase quality standards and reduce the industrial cost of the finished product, with respect to the conventional solutions.

In conclusion, the advantageous configuration proposed allows to optimize efficiency, electrical and thermal performances, cost-effectiveness, reliability, the times for processing and assembling the cell, the conductive backsheet and the whole photovoltaic module; in particular, industrial production costs are reduced and, as a consequence, it is possible to considerably reduce the cost per Watt of photovoltaic energy.

These and other advantages will appear from the following detailed description of some preferred embodiments, with the aid of the schematic drawings enclosed whose details of execution are not to be considered limitative but only illustrative.

### Content of the drawings

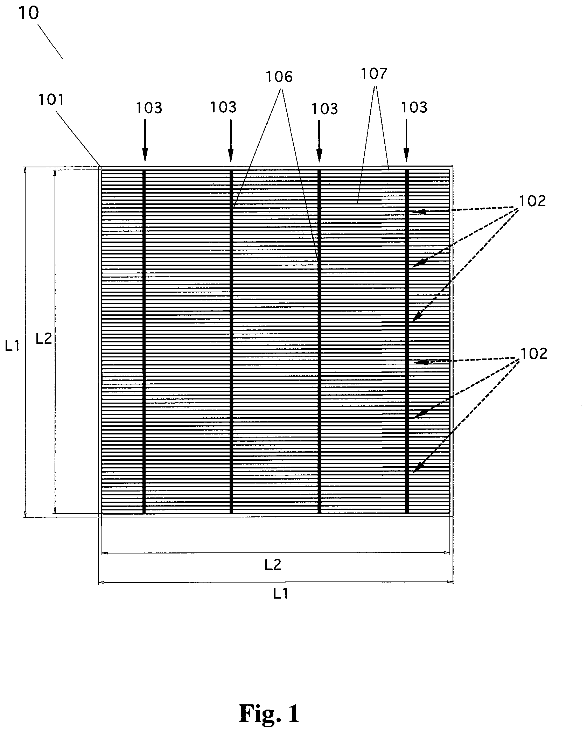

Figure 1 orthogonally shows the front face of the MWT cell provided by the invention in a possible variant of front metallization, wherein the N through-holes are aligned under the busbars of connection with orthogonal collection fingers; said Figure 1 is intended to facilitate the understanding of the invention, which relates to the particular configuration of the electrical contacts on the back face of said MWT cell, also with said N holes.

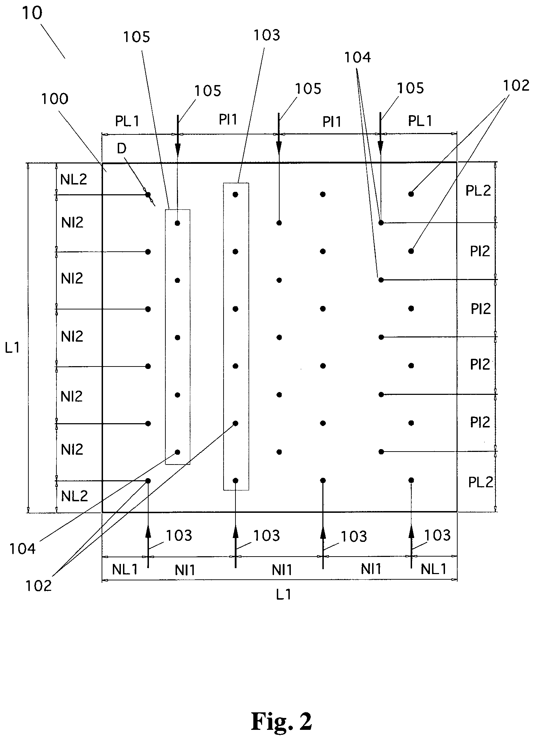

Figure 2 orthogonally shows the back face of the MWT cell as provided by the invention.

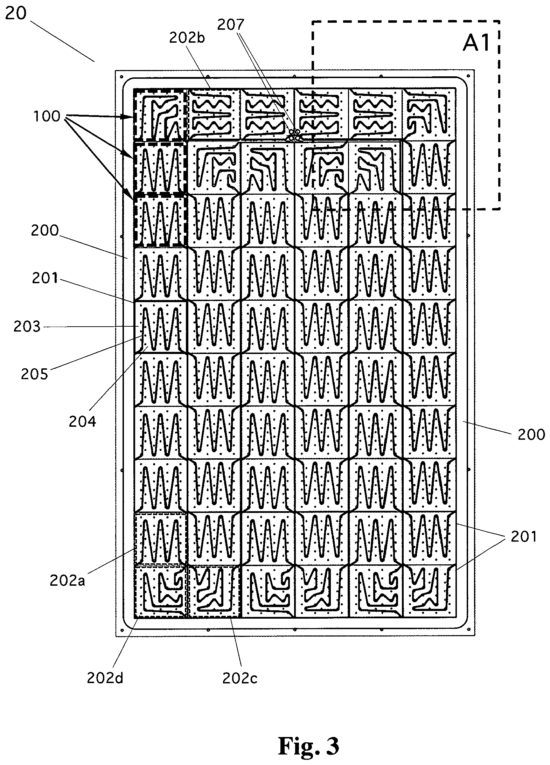

Figure 3 orthogonally shows the inside of the conductive backsheet as provided by the invention, it being intended to electrically connect the back face of said MWT cells which are placed side by side in such a way as to form, for example, a photovoltaic panel made up of 60 cells; the contacts relating to the N holes and to the P points of said cells are schematically indicated for the purpose of facilitating the understanding of the electrical circuit.

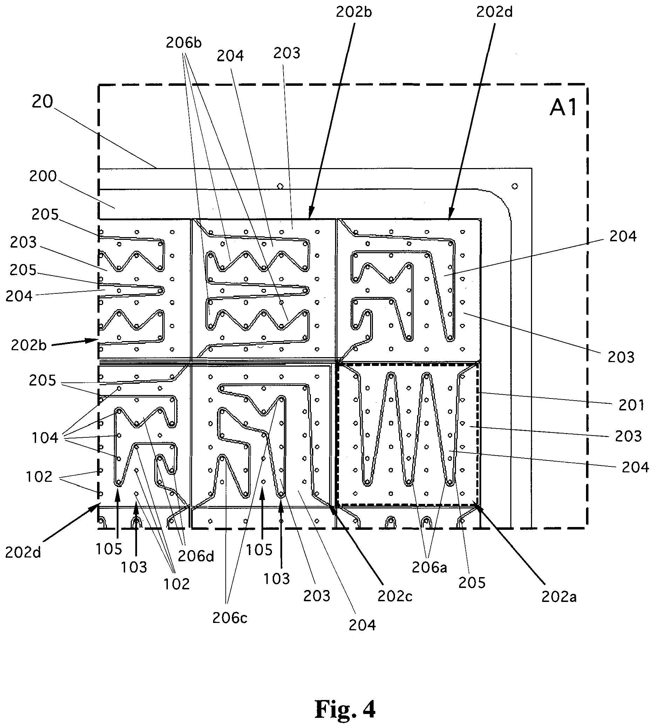

Figure 4 is a detail view of the conductive backsheet concerning the detail A1 of Figure 3, which highlights four different contacting configurations in correspondence of cells located on the panel in different positions.

### Description of at least one embodiment of the invention

The present invention describes a back-contact photovoltaic cell (10) of crystalline silicon of the type called Metal Wrap Through, also known by the acronym MWT, for a dedicated conductive backsheet (20). Said photovoltaic cell has through-holes for the electrons and punctiform back contacts for the charges of opposite sign, called N holes (102) and P points (104) respectively, having an advantageous configuration so as to enable automated industrial production and facilitate the association with a coplanar direct contacting support of the conductive backsheet (20) type. Said backsheet integrates on the face facing the cells a conductive layer (200) which is intended to electrically connect by strings said N holes and P points of all the cells completing the electrical circuitry of the whole photovoltaic panel, otherwise known as module, up to the contacting blocks (207) of the junction box. Such a solution of direct and punctual contacting prevents the welding or insertion of conductive ribbons of electrical connection between said N and P contacts and also reduces metallization costs; the invention also allows to solve the known problems of electrical connection between MWT cells and a conductive backsheet in any configuration of string and/or panel and in any position of the cells, particularly in correspondence of the corners of the panel.

In more detail, the MWT cell (10) according to the invention is square with a width (L1) of 156 mm, considering a tolerance of +/- 0.5 mm, and comprises 24 N through-holes, called N holes (102), and 15 P contacts of the localised type, that is to say, of limited area in the form of single points, called P points (104). Therefore, on the back face (100) of the cell there are both electrical contacts of opposite sign, that is to say, said N holes and P points, which are punctiform and aligned in parallel rows (103, 105): the N holes (102) are aligned along 4 parallel rows, which are also called N rows (103), that is to say, 6x4N, and said P points (104) are aligned along 3 rows, which are also called P rows (105), that is to say, 5x3P. The P rows are interposed to said N rows, with the second P row positioned centrally with respect to the cell, like a centre line (Figures 1-2). Therefore, the present invention proposes an advantageous configuration of the electrical contacts on the back face (100) of a MWT cell (10), that is to say, in correspondence of said N holes (102) and P points (104); we would like to point out that, for the purposes of the invention, the front face (101) of said cell can comprise any configuration and/or type of front metallization anyway respecting the crossings of the negative electrical charges in correspondence of said N holes, they being passing-through and corresponding in the opposite face. As a non-exhaustive example, suitable for the invention is a metallized collection area of the orthogonal pattern type (Fig. 1) having a width (L2) a little smaller than said width (L1) of the cell wherein said N holes are aligned on the connection busbars (106) of the collection fingers (107) orthogonal to them, they being arranged at a constant pace and parallel to each other; as an alternative, suitable for the invention is a radial arrangement of the fingers, originated from said N holes, or any other configuration suitable for improving the front collection according to the aims of the invention.

The N holes (102), the N rows (103), the P points (104) and the P rows (105) are thus on the back face (100) of the cell (10) in a particular number, shape and position (Fig. 2):
- the 4 N rows (103) are formed by 6 N holes (102) each, for a total of 24 N holes;
- the 3 P rows (105) are formed by 5 P points (104) each, for a total of 15 P points;
- the centre-to-centre distance (NI1) between the N rows (103) is constant and is of 38.5 mm, there remaining a space from the side edge (NL1) which is complementary and symmetrical with respect to the opposite edge, that is to say, it is of 20.25 mm;
- the centre-to-centre distance (PI1) between the P rows (105) is constant and is of 44.7 mm, there remaining a space from the side edge (PL1) which is complementary and symmetrical with respect to the opposite edge, that is to say, it is of 33.3 mm;
- the P points (104) of each P row (105) are offset in an alternate way with respect to said N holes (102), that is to say, with the centre-to-centre distance (PI2) on the centre line (102, NI2);
- the N holes (102) of each N row (103) have a centre-to-centre distance (NI2) which is constant and is of 25.5 mm, there remaining a space from the side edge (NL2) which is complementary and symmetrical with respect to the opposite edge, that is to say, it is of 14.25 mm;
- the P points (104) of each P row (105) have a centre-to-centre distance (PI2) which is constant and is of 25.5 mm, there remaining a space from the side edge (NL2) which is symmetrically complementary, that is to say, it is of 27 mm;
- all the above values being considered with a tolerance of +/- 5%.

In the preferred configuration (Fig. 2) it is provided that said N holes (102) have a diameter (D) between 80 micrometres and 220 micrometres, being for example of 200 micrometres; moreover, it is provided that said P points (104) are circular with a diameter between 1 mm and 4 mm, being for example of 2.5 mm. In more detail as to the preferred but not exclusive embodiment, said N holes (102) are filled with a silver-based conductive paste to be connected to a wider conductive pad, which, too, consists of a silver-based conductive paste, printed on the back of the cell and centred with respect to said hole, with a diameter wider than the hole itself in such a way as to facilitate connection by means of a conductive adhesive to the opposite conductive backsheet.

Said cell (10) (Figures 1-2) is for a conductive backsheet (20) (Fig. 3) having the contacting conductive layer (200) which is subdivided into multiple square areas (201) individually corresponding to each cell (10, 100) of the photovoltaic panel; each of said square areas is internally subdivided into two portions (203-4) complementary to each other, being separated for the purpose of electrical insulation by a separation cut (205) having a constant width, between 0.5 mm and 3 mm. Said separation cut (205) follows a path which develops in a continuous and rounded zigzag pattern, that is to say, without sharp-edged changes in direction, in such a way as to partially wrap around said N holes (102) and/or said P points (104) joining for each cell (10, 100) all the electrical contacts of the same sign and excluding the others, that is to say, realizing a first N portion (203) intended to electrically join said N holes (102) and there remaining a second P portion (204) which is intended to electrically join said P points (104).

In more detail (Figures 3-4), said separation cut (205) delimits peninsulas configured as teeth (206a-d), also joined to each other, having the sides with a convergent-divergent profile in such a way as to narrow at the end, partially wrapping around the element to be contacted (102, 104), and conduct the electric flux with a non-constant section which is proportionate to the quantity and to the position of the contacted elements. It is basically provided that, to the increase in the number of contacted electrodes must correspond a growing width of the corresponding conductive layer, with an equal rolled thickness. Therefore, it is noted that the conductive sections can be variable, since they are locally determined by the width in each individual portion of said teeth multiplied by the thickness of the conductive layer (200), which is preferably of 35 micrometres if it is of copper or of 55 micrometres if it is of aluminium.

The arrangement of the conductive pads intended to be connected to the external junction box placed on the back of the finished panel, conventionally called contacting blocks (207), depends on the junction box used and on the configuration of the panel. To this purpose, in fact, we remind that nowadays junction boxes with different configurations of the contacts are available on the market; for example, it is possible to realize a symmetrical arrangement with four blocks centrally grouped in a square in correspondence of the first row of cells (Fig. 3). The invention (10, 20) allows to provide said contacting blocks (207) in such a way as to adapt to the particular junction box used and also allows to realize multiple photovoltaic panel configurations, it being possible to arrange said cells (10) on said conductive backsheet (20) according to a different number or to a different positioning, in order to make, as a non-exhaustive example, photovoltaic panels with 60 cells (Fig. 3) or panels with 48 cells, with two less rows of cells, or even panels with 72 cells, with two more rows of cells.

The preferred configuration of a conductive backsheet (20) dedicated to the contacting of the cell (10, 100) according to the invention, provides at least one of the following contacting configurations (202a-d) for each square area (201) of the back face (100) (Figures 3-4):
- a first configuration (202a) is of the double comb type with wide teeth (206a) like fingers which penetrate each other frontally in a complementary way, wherein each tooth selectively contacts a whole row (103, 105);
- a second configuration (202b) in which the teeth (206b) of said comb are arranged orthogonally with respect to said rows (103, 105) and wherein the central ones widen and narrow in such a way as to comprise two adjacent contacts of the same sign;
- a third configuration (202c) in which the teeth (206c) are mainly L-shaped in such a way as to adapt to the corners and/or to the end of the strings, combining a partially superimposed and partially orthogonal arrangement with respect to said rows (103, 105), wherein the shortest tooth develops without bending;
- a fourth configuration (202d), which is an alternative variant with respect to said third configuration (202c), in which the shortest tooth (206d) bends laterally.

In order to make a photovoltaic panel with 60 cells (Fig. 3), said conductive backsheet (20) provides 60 contacting square areas (201) arranged on 6 adjacent rows of 10 areas (201) each, wherein:
- said first contacting configuration (202a) is present 44 times, that is to say, 8 times in the two side rows and 7 times in the four central rows;
- said second contacting configuration (202b) is present 4 times in each of said central rows;
- said third and fourth contacting configurations (202c-d) are present 8 times as a whole, that is to say, twice in each row and at least once at the end in such a way that in the four corners of said conductive backsheet (20) there is always at least one of said configurations (202c-d).

Said conductive backsheet (20) has at least one conductive layer (200), processed as described above, coupled with a back supporting panel. In an advantageous alternative embodiment of the invention, aimed at the automated assembly of photovoltaic panels with large production volumes using a modern industrial automatic production and control plant as for example in ITTV2013A000192 (Spotti et al.), a composite structure of a conductive backsheet of the integrated, multilayer and multifunction type is provided. For example, see the advantageous solution of a conductive backsheet described in ITTV2012A000211 (Baccini et al.), which also comprises a semi-finished layered element of the type described in ITVI2012A000133 (Baccini et al.).

In more detail, such a conductive backsheet integrates a plurality of superimposed layers with diversified specific functions, comprising at least: one insulating dielectric back layer which acts as a support and which in its turn is made up of at least two layers the most external of which remains exposed to the air and is therefore treated to be able to resist more to hydrolysis and to ultraviolet rays, a conductive metal layer which is suitably configured for the back contacting of the cells in series, a multilayer element of the composite type which is holed in correspondence of the contacts and is formed by a first layer of encapsulating or thermoadhesive material in contact with the conductive layer and by a second layer of encapsulating or thermoadhesive material in contact with the cells placed on the upper part, among which an internal layer of dielectric material is interposed, which acts as a selective insulating mask. Furthermore, in order to allow the electrical contacting with the junction box, holes are made on said conductive backsheet, which are intended for the passage of the conductive elements; to this purpose, widely known are the conventional solutions in which the contacting is carried out with a manual process and also known are evolved solutions which simplify the assembly of said box eliminating any handling of the internal elements, which are extremely delicate. Among them one should remember, as a non-exhaustive example, the solutions described in ITTV20130059 (Baccini et al.) and ITTV20130060 (Baccini et al.) which provide particular passing-through conductive elements that are fixed to said conductive backsheet being interposed between the face facing said box and the face facing the cells, where they are integrated in a lowered seat in such a way as to enable direct contacting in adhesion with the conductive layer of the backsheet.

The assembled structure of a photovoltaic panel with a back-contact architecture with said MWT cells and comprising said layered and multifunction conductive backsheet is thus simplified with respect to the conventional solutions since it is formed, in sequence from the back side, by: a conductive backsheet (20) with integrated encapsulating and dielectric material, said MWT photovoltaic cells (10), a conductive adhesive for example of the type called ECA, a front encapsulating layer, a front glass. The back layer of support of said conductive backsheet can in its turn be of the composite type, according to the known art, being formed by different normally polymeric and adhesive layers with diversified functions dedicated to the protection from the weather conditions, such as humidity and UV rays. As a non-exhaustive example, we would like to point out the embodiment variant of the multilayer type consisting of a PET layer against UV rays, a vapour barrier, the supporting BS layer and a primer layer of EVA; moreover, we also would like to point out the embodiment variant of the metal conductive layer protected by an anti-corrosion layer.

### Reference

(10) back-contact photovoltaic cell of crystalline silicon of the type called Metal Wrap Through or MWT;
(100) back face of the cell, towards the conductive backsheet;
(101) front face of the cell, exposed to the light;
(102) internally metallized N through-hole, called N hole;
(103) row of aligned N holes;
(104) contacting P point;
(105) row of aligned P points;
(106) connection busbars;
(107) collection fingers;
(20) conductive backsheet;
(200) conductive layer of the backsheet:
(201) contacting square area of a cell;
(202a-d) alternative contacting configurations of a cell, respectively corresponding to a first (202a), a second (202b), a third (202c) or a fourth
(202d) configuration;
(203) portion of area intended to contact all the N holes of the cell, called first N portion;
(204) portion of area intended to contact all the P points of the cell, called second P portion;
(205) separation cut;
(206a-d) peninsulas in the form of teeth with convergent-divergent sides, called teeth and respectively referred to the first, second, third and fourth contacting configuration;
(207) contacting blocks of the junction box;
(L1) width of the cell;
(L2) width of the metallized collection area;
(NI1) centre-to-centre distance between the N rows;
(NI2) centre-to-centre distance between the N holes;
(NL1) space of the last N row from the side edge;
(NL2) space of the last N hole from the side edge;
(PI1) centre-to-centre distance between the P rows;
(PI2) centre-to-centre distance between the P points;
(PL1) space of the last P row from the side edge;
(PL2) space of the last P point from the side edge.

## Claims

1. Back-contact photovoltaic cell (10) of crystalline silicon of the type called Metal Wrap Through or MWT, for a dedicated conductive backsheet (20), said cell (10) being intended to be supported and electrically contacted only on the back face (100) by means of said conductive backsheet (20) which, acting as a support and back completion of a photovoltaic panel with a back-contact architecture comprising multiple cells (10), integrates on the face facing the cells (10) a contacting conductive layer (200) which is electrically connected to N through-holes (102) and to back contacting P points (104) of said cells (10), called N holes and P points respectively, in such a way as to complete the electrical circuit of said photovoltaic panel up to the contacting blocks (207) of the junction box; said cell (10) being of square configuration and having a width (L1) of 156 mm with a tolerance of +/- 0.5 mm; said cell (10) having said N holes (102) aligned along 4 parallel rows called N rows (103) and said P points (104) aligned along 3 parallel rows called P rows (105), wherein said P rows (105) are interposed to said N rows (103) with the second P row positioned centrally like a centre line of said back face (100) of the cell (10); said N rows (103) and P rows (105) being in their turn parallel to each other; said cell (10) being **characterised in that** it has said back face (100) having said N rows (103) formed by 6 N holes (102) each, for a total of 24 N holes, and having said P rows (105) formed by 5 P points (104) each, for a total of 15 P points, wherein the centre-to-centre distance (NI1) between said N rows (103) is constant and is of 38.5 mm, there remaining a space from the side edge (NL1) which is complementary and symmetrical with respect to the opposite edge, that is to say, it is of 20.25 mm, and wherein the centre-to-centre distance (PI1) between said P rows P (105) is constant and is of 44.7 mm, there remaining a space from the side edge (PL1) which is complementary and symmetrical with respect to the opposite edge, that is to say, it is of 33.3 mm, with said values having a tolerance of +/- 5%; said P points (104) of each P row (105) being offset in an alternate way with respect to said N holes (102) or with the centre-to-centre distance (PI2) on the centre line (102, NI2); said N holes (102) of each N row (103) having a centre-to-centre distance (NI2) which is constant and is of 25.5 mm, there remaining a space from the side edge (NL2) which is complementary and symmetrical with respect to the opposite edge, that is to say, it is of 14.25 mm, with said values having a tolerance of +/- 5%; said P points (104) of each P row (105) having a centre-to-centre distance (PI2) which is constant and is of 25.5 mm, there remaining a space from the side edge (NL2) which is symmetrically complementary, that is to say, it is of 27 mm, with said values having a tolerance of +/- 5%; and wherein said N holes (102) have a diameter (D) between 80 micrometres and 220 micrometres, while said P points (104) are circular, with a diameter between 1 mm and 4 mm.

2. Photovoltaic cell (10) according to the previous claim, **characterised in that** it is associated with a conductive backsheet (20) having the contacting conductive layer (200) subdivided into square areas (201) which are individually intended to contact said cell (10), said square areas (201) being in correspondence of each cell (10) constituting said photovoltaic panel with a back-contact architecture; and wherein each of said square areas (201) is internally subdivided into two portions (203-4) complementary to each other, separated for the purposes of electrical insulation by a separation cut (205) having a constant width, between 0.5 mm and 3 mm; said separation cut (205), following a path which develops in a continuous and rounded zigzag pattern, that is to say, without sharp-edged changes in direction, in such a way as to partially wrap around said N holes (102) and/or said P points (104) joining for each cell (10, 100) all the electrical contacts of the same sign and excluding the others, that is to say, realizing a first N portion (203) intended to electrically join all said N holes (102) of the cell (10) and there remaining a second P portion (204) which is intended to electrically join all said P points (104) of the same cell (10).

3. Photovoltaic cell (10) according to the previous claims, **characterised in that** it is associated with a conductive backsheet (20) which comprises said contacting square areas (201) wherein said zigzag separation cut (205) delimits peninsulas configured as teeth (206a-d) having the sides with a convergent-divergent profile in such a way as to narrow at the end, partially wrapping around the element to be contacted (102, 104), and conduct the electric flux with a non-constant section, that is to say, proportionate to the quantity and to the position of the contacted elements; and wherein in said conductive backsheet (20) there is at least one of the following contacting configurations (202a-d) for each square area (201) of said back face (100) of the cell (10):
- a first configuration (202a) is of the double comb type with wide teeth (206a), like fingers which penetrate each other frontally in a complementary way, wherein each tooth selectively contacts a whole row (103, 105);
- a second configuration (202b) in which the teeth (206b) of said comb are arranged orthogonally with respect to said rows (103, 105) and wherein the central teeth widen and narrow in such a way as to comprise two adjacent contacts of the same sign;
- a third configuration (202c) in which the teeth (206c) are mainly L-shaped in such a way as to adapt to the corners and/or to the end of the strings, combining a partially superimposed and partially orthogonal arrangement with respect to said rows (103, 105), wherein the shortest tooth develops without bending;
- a fourth configuration (202d), which is an alternative variant with respect to said third configuration (202c), in which the shortest tooth (206d) bends laterally.

4. Photovoltaic cell (10) according to the previous claims, **characterised in that** it is associated with a conductive backsheet (20) having at least 48 contacting square areas (201) for contacting an equal number of said cells (10), and wherein said first contacting configuration (202a) is at least equal to 70% of the total number of said square areas (201) and is present in all the strings.

5. Photovoltaic cell (10) according to claims 1 to 4, **characterised in that** it is associated with a conductive backsheet (20) comprising at least 4 contacting square areas (201) having said second contacting configuration (202b).

6. Photovoltaic cell (10) according to at least claims 1 to 4, **characterised in that** it is associated with a conductive backsheet (20) comprising at least 4 contacting square areas (201) having said third contacting configuration (202c).

7. Photovoltaic cell (10) according to at least claims 1 to 4, **characterised in that** it is associated with a conductive backsheet (20) comprising at least 4 contacting square areas (201) having said fourth contacting configuration (202d).

8. Photovoltaic cell (10) according to at least claims 1 to 4, **characterised in that** it is associated with a conductive backsheet (20) having 60 contacting square areas (201) arranged in 6 adjacent rows of 10 square areas (201) each, wherein said first contacting configuration (202a) is present 44 times, that is to say, 8 times in the two side rows and 7 times in the four central rows; and wherein said second contacting configuration (202b) is present 4 times in each of said central rows; and wherein said third and fourth contacting configurations (202c-d) are present 8 times as a whole, that is to say, twice in each row and at least once at the end in such a way that in the four corners of said conductive backsheet (20, 200) there is always at least one of them (202c-d).

9. Photovoltaic cell (10) according to at least claims 1 to 4, **characterised in that** it is associated with a conductive backsheet (20) having 48 contacting square areas (201) arranged in 6 adjacent rows of 8 areas (201) each, wherein said first contacting configuration (202a) is present 32 times, that is to say, 6 times in the two side rows and 5 times in the four central rows; and wherein said second contacting configuration (202b) is present 4 times in each of said central rows; and wherein said third and fourth contacting configurations (202c-d) are present 8 times as a whole, that is to say, twice in each row and at least once at the end in such a way that in the four corners of said conductive backsheet (20, 200) there is always at least one of them (202c-d).

10. Photovoltaic cell (10) according to at least claims 1 to 4, **characterised in that** it is associated with a conductive backsheet (20) having 72 contacting square areas (201) arranged in 6 adjacent rows of 12 areas (201) each, wherein said first contacting configuration (202a) is present 56 times, that is to say, 10 times in the two side rows and 9 times in the four central rows; and wherein said second contacting configuration (202b) is present 4 times in each of said central rows; and wherein said third and fourth contacting configurations (202c-d) are present 8 times as a whole, that is to say, twice in each row and at least once at the end in such a way that in the four corners of said conductive backsheet (20, 200) there is always at least one of them (202c-d).

## Patentansprüche

1. Rückseitenkontakt-Photovoltaikzelle (10) aus kristallinem Silizium vom Typ Metal-Wrap-Through oder MWT, für eine spezielle leitfähige Rückseitenschicht (20), besagte Zelle (10) soll nur auf der Rückseite (100) mittels besagter leitfähigen Rückseitenschicht (20) unterstützt und elektrisch kontaktiert werden, die als Unterstützung und Rückseitenvervollständigung einer Photovoltaikplatte mit einer Rückkontaktarchitektur mit mehreren Zellen (10) wirkt und auf der Seite, die den Zellen (10) gegenüberliegt, eine kontaktierende leitfähige Schicht (200) umfasst, die elektrisch mit N-Durchgangsbohrungen (102) verbunden ist und mit rückkontaktierenden P-Punkten (104) von besagten Zellen (10), N-Löcher bzw. P-Punkte genannt, um den elektrischen Schaltkreis der besagten photovoltaischen Platte bis zu den kontaktierenden Blöcken (207) der Anschlussdose hin zu vervollständigen; besagte Zelle (10) ist quadratisch und hat eine Breite (L1) von 156 mm mit einer Toleranz von +/-0,5 mm; besagte Zelle (10) hat besagte N-Löcher (102) entlang 4 parallelen Reihen ausgerichtet, genannt N-Reihen (103), und besagte P-Punkte (104) sind entlang 3 parallelen Reihen ausgerichtet, genannt P-Reihen (105), wobei besagte P-Reihen (105) zwischen besagten N-Reihen (103) liegen, wobei die zweite P-Reihe zentral positioniert ist, wie eine Mittenlinie von besagter Rückseite (100) der Zelle (10); besagte N-Reihen (103) und P-Reihen (105) sind ihrerseits parallel zueinander; besagte Zelle (10) ist **dadurch gekennzeichnet, dass** sie besagte Rückseite (100) mit besagten N-Reihen (103) aufweist, die aus je 6 N-Löchern (102) gebildet sind, insgesamt 24 N-Löcher, und besagte P-Reihen (105) sind aus je 5 P-Punkten (104) gebildet, insgesamt 15 P-Punkte, wobei der Mittenabstand (NI1) zwischen besagten N-Reihen (103) konstant ist und 38,5 mm beträgt, es verbleibt ein Raum von der Seitenkante (NL1), der komplementär und symmetrisch in Bezug auf die gegenüberliegende Kante ist, d. h. er beträgt 20,25 mm, und wobei der Mittenabstand (PI1) zwischen besagten P-Reihen P (105) konstant ist und 44,7 mm beträgt, es verbleibt ein Raum von der Seitenkante (PL1), der komplementär und symmetrisch in Bezug auf die gegenüberliegende Kante ist, d. h. er beträgt 33,3 mm, wobei besagte Werte eine Toleranz von +/- 5% haben; besagte P-Punkte (104) jeder P-Reihe (105) sind in Bezug auf besagte N-Löcher (102) abwechselnd versetzt oder mit dem Mittenabstand (PI2) auf der Mittenlinie (102, NI2); besagte N-Löcher (102) jeder N-Reihe (103) haben einen Mittenabstand (NI2), der konstant ist und 25,5 mm beträgt, es verbleibt ein Raum von der Seitenkante (NL2), der komplementär und symmetrisch in Bezug auf die gegenüberliegende Kante ist, d. h. er beträgt 14,25 mm, wobei besagte Werte eine Toleranz von +/- 5% haben; besagte P-Punkte (104) jeder P-Reihe (105) haben einen Mittenabstand (PI2), der konstant ist und 25,5 mm beträgt, es verbleibt ein Raum von der Seitenkante (NL2), der symmetrisch komplementär ist, d. h. er beträgt 27 mm, wobei besagte Werte eine Toleranz von +/- 5% haben; und wobei besagte N-Löcher (102) einen Durchmesser (D) zwischen 80 Mikrometern und 220 Mikrometern haben, während besagte P-Punkte (104) rund sind, mit einem Durchmesser zwischen 1 mm und 4 mm.

2. Photovoltaische Zelle (10) nach dem vorherigen Anspruch, **dadurch gekennzeichnet, dass** sie mit einer leitfähigen Rückseitenschicht (20) verbunden ist, wobei die kontaktierende leitfähige Schicht (200) in quadratische Bereiche (201) unterteilt ist, die einzeln besagte Zelle (10) kontaktieren sollen, besagte quadratische Bereiche (201) sind an jeder Zelle (10) und bilden besagte photovoltaische Platte mit einer Rückkontaktarchitektur; und wobei jeder der quadratischen Bereiche (201) innen in zwei Teile (203-4) unterteilt ist, die zueinander komplementär sind, zum Zweck der elektrischen Isolierung durch einen Trennschnitt (205) getrennt, mit einer konstanten Breite, zwischen 0,5 mm und 3 mm; besagter Trennschnitt (205) folgt einer Bahn, die ein kontinuierliches und abgerundetes Zickzackmuster hat, d. h. ohne scharfe Richtungswechsel, um besagte N-Löcher (102) und/oder besagte P-Punkte (104) teilweise zu umhüllen, mit Verbindung, für jede Zelle (10, 100), aller elektrischen Kontakte desselben Vorzeichens und unter Ausschluss der anderen, d. h. Schaffung eines ersten N-Teils (203), das alle besagten N-Löcher (102) der Zelle (10) elektrisch verbinden soll, wobei ein zweites P-Teil (204) verbleibt, das alle besagten P-Punkte (104) derselben Zelle (10) elektrisch verbinden soll.

3. Photovoltaische Zelle (10) nach den vorhergehenden Ansprüchen, **dadurch gekennzeichnet, dass** sie mit einer leitfähigen Rückseitenschicht (20) verbunden ist, die besagte kontaktierende quadratische Bereiche (201) umfasst, wobei besagter Zickzack-Trennschnitt (205) Halbinseln begrenzt, die als Zähne (206a-d) konfiguriert sind, mit Seiten mit konvergentemdivergentem Profil, so dass sie sich am Ende verengen und teilweise das zu kontaktierende Element (102, 104) umhüllen und den elektrischen Strom mit einem nicht konstanten Querschnitt leiten, d. h. je nach der Menge und der Position der kontaktierten Elemente; und wobei in besagter leitfähiger Rückseitenschicht (20) mindestens eine der folgenden kontaktierenden Konfigurationen (202a-d) für jede Quadratfläche (201) besagter Rückseite (100) der Zelle (10) vorhanden ist:
- eine erste Konfiguration (202a) ist ein doppelter Kamm mit weiten Zähnen (206a), wie Finger, die einander frontal komplementär durchdringen, wobei jeder Zahn selektiv eine ganze Reihe (103, 105) kontaktiert;
- eine zweite Konfiguration (202b), bei der die Zähne (206b) des besagten Kamms rechtwinklig in Bezug auf besagte Reihen (103, 105) angeordnet sind und wobei die zentralen Zähne sich derart ausweiten und verengen, dass sie zwei benachbarte Kontakte mit demselben Vorzeichen umfassen;
- eine dritte Konfiguration (202c), bei der die Zähne (206c) vorwiegend L-förmig sind, so dass sie sich an die Ecken und/oder das Ende der Reihen anpassen und in Kombination eine teilweise übereinandergelegte und teilweise rechtwinklige Anordnung in Bezug auf besagten Reihen (103, 105) einnehmen, wobei der kürzeste Zahn keine Biegung aufweist;
- eine vierte Konfiguration (202d), die eine alternative Variante in Bezug auf besagte dritte Konfiguration (202c) ist, wobei der kürzeste Zahn (206d) sich seitlich biegt.

4. Photovoltaische Zelle (10) nach den vorhergehenden Ansprüchen, **dadurch gekennzeichnet, dass** sie mit einer leitfähigen Rückseitenschicht (20) verbunden ist, die mindestens 48 kontaktierende quadratische Bereiche (201) zum Kontaktieren einer gleichen Zahl von besagten Zellen (10) aufweist, und wobei besagte erste kontaktierende Konfiguration (202a) mindestens gleich 70% der gesamten Zahl besagter quadratischen Bereiche (201) ist und in allen Reihen vorhanden ist.

5. Photovoltaische Zelle (10) nach einem der Ansprüche 1 bis 4, **dadurch gekennzeichnet, dass** sie mit einer leitfähigen Rückseitenschicht (20) verbunden ist, die mindestens 4 kontaktierende quadratische Bereiche (201) aufweist, die besagte zweite kontaktierende Konfiguration (202b) haben.

6. Photovoltaische Zelle (10) nach mindestens den Ansprüchen 1 bis 4, **dadurch gekennzeichnet, dass** sie mit einer leitfähigen Rückseitenschicht (20) verbunden ist, die mindestens 4 kontaktierende quadratische Bereiche (201) aufweist, die besagte dritte kontaktierende Konfiguration (202c) haben.

7. Photovoltaische Zelle (10) nach mindestens den Ansprüchen 1 bis 4, **dadurch gekennzeichnet, dass** sie mit einer leitfähigen Rückseitenschicht (20) verbunden ist, die mindestens 4 kontaktierende quadratische Bereiche (201) aufweist, die besagte vierte kontaktierende Konfiguration (202d) haben.

8. Photovoltaische Zelle (10) nach mindestens den Ansprüchen 1 bis 4, **dadurch gekennzeichnet, dass** sie mit einer leitfähigen Rückseitenschicht (20) verbunden ist, die 60 kontaktierende quadratische Bereiche (201) aufweist, die in 6 benachbarten Reihen à 10 quadratische Bereiche (201) angeordnet sind, wobei besagte erste kontaktierende Konfiguration (202a) 44-mal vorhanden ist, d. h. 8-mal in den beiden Seitenreihen und 7-mal in den vier zentralen Reihen; und wobei besagte zweite kontaktierende Konfiguration (202b) 4-mal in jeder der besagten zentralen Reihen vorhanden ist; und wobei besagte dritte und vierte kontaktierende Konfiguration (202c-d) insgesamt 8-mal vorhanden sind, d. h. zweimal in jeder Reihe und mindestens einmal am Ende, so dass in den vier Ecken besagter leitfähiger Rückseitenschicht (20, 200) immer mindestens eine von ihnen (202c-d) vorhanden ist.

9. Photovoltaische Zelle (10) nach mindestens den Ansprüchen 1 bis 4, **dadurch gekennzeichnet, dass** sie mit einer leitfähigen Rückseitenschicht (20) verbunden ist, die 48 kontaktierende quadratische Bereiche (201) aufweist, die in 6 benachbarten Reihen à 8 Bereiche (201) angeordnet sind, wobei besagte erste kontaktierende Konfiguration (202a) 32-mal vorhanden ist, d. h. 6-mal in den beiden Seitenreihen und 5-mal in den vier zentralen Reihen; und wobei besagte zweite kontaktierende Konfiguration (202b) 4-mal in jeder der besagten zentralen Reihen vorhanden ist; und wobei besagte dritte und vierte kontaktierende Konfiguration (202c-d) insgesamt 8-mal vorhanden sind, d. h. zweimal in jeder Reihe und mindestens einmal am Ende, so dass in den vier Ecken von besagter leitfähiger Rückseitenschicht (20, 200) immer mindestens eine von ihnen (202c-d) vorhanden ist.

10. Photovoltaische Zelle (10) nach mindestens den Ansprüchen 1 bis 4, **dadurch gekennzeichnet, dass** sie mit einer leitfähigen Rückseitenschicht (20) verbunden ist, die 72 kontaktierende quadratische Bereiche (201) aufweist, die in 6 benachbarten Reihen à 12 Bereiche (201) angeordnet sind, wobei besagte erste kontaktierende Konfiguration (202a) 56-mal vorhanden ist, d. h. 10-mal in den beiden Seitenreihen und 9-mal in den vier zentralen Reihen; und wobei besagte zweite kontaktierende Konfiguration (202b) 4-mal in jeder der besagten zentralen Reihen vorhanden ist; und wobei besagte dritte und vierte kontaktierende Konfiguration (202c-d) insgesamt 8-mal vorhanden sind, d. h. zweimal in jeder Reihe und mindestens einmal am Ende, so dass in den vier Ecken von besagter leitfähiger Rückseitenschicht (20, 200) immer mindestens eine von ihnen (202c-d) vorhanden ist.

## Revendications

1. Cellule photovoltaïque à contact arrière (10) en silicium cristallin du type appelé Metal Wrap Through ou MWT, pour une couche arrière conductrice dédiée (20), ladite cellule (10) étant destinée à être supportée et contactée électriquement seulement sur la face postérieure (100) au moyen de ladite couche arrière conductrice (20) qui, agissant comme un support et accomplissement postérieur d'un panneau photovoltaïque avec une architecture à contact arrière comprenant des cellules multiples (10), intègre sur la face orientée vers les cellules (10) une couche conductrice de mise en contact (200) qui est électriquement connectée à des trous de passage N (102) et à des points P de mise en contact arrière (104) desdites cellules (10), appelés trous N et points P respectivement, de façon à compléter le circuit électrique dudit panneau photovoltaïque jusqu'aux blocs de mise en contact (207) de la boîte de dérivation ; ladite cellule (10) étant à configuration carrée et ayant une largeur (L1) de 156 mm avec une tolérance de +/-0,5 mm ; ladite cellule (10) ayant lesdits trous N (102) alignés le long de 4 rangées parallèles appelées rangées N (103) et lesdits points P (104) alignés le long de 3 rangées parallèles appelées rangées P (105), où lesdites rangées P (105) sont intercalées auxdites rangées N (103) avec la deuxième rangée P positionnée centralement comme une ligne médiane de ladite face postérieure (100) de la cellule (10) ; lesdites rangées N (103) et rangées P (105) étant à leur tour parallèles l'une à l'autre ; ladite cellule (10) étant **caractérisée** en ce quelle a ladite face postérieure (100) ayant lesdites rangées N (103) formées de 6 trous N (102) chacune, pour un total de 24 trous N, et ayant lesdites rangées P (105) formées de 5 points P (104) chacune, pour un total de 15 points P, où l'entraxe (NI1) entre lesdites rangées N (103) est constant et est de 38,5 mm, y restant un espace partant du bord latéral (NL1) qui est complémentaire et symétrique par rapport au bord opposé, c'est-à-dire, il est de 20,25 mm, et où l'entraxe (PI1) entre lesdites rangées P (105) est constant et est de 44,7 mm, y restant un espace partant du bord latéral (PL1) qui est complémentaire et symétrique par rapport au bord opposé, c'est-à-dire, il est de 33,3 mm, lesdites valeurs ayant une tolérance de +/-5 % ; lesdits points P (104) de chaque rangée P (105) étant décalés de façon alternée par rapport auxdits trous N (102) ou avec l'entraxe (PI2) sur la ligne médiane (102, NI2) ; lesdits trous N (102) de chaque rangée N (103) ayant un entraxe (NI2) qui est constant et est de 25,5 mm, y restant un espace partant du bord latéral (NL2) qui est complémentaire et symétrique par rapport au bord opposé, c'est-à-dire, il est de 14,25 mm, lesdites valeurs ayant une tolérance de +/-5 % ; lesdits points P (104) de chaque rangée P (105) ayant une distance d'entraxe (PI2) qui est constante et est de 25,5 mm, y restant un espace partant du bord latéral (NL2) qui est symétriquement complémentaire, c'est-à-dire, il est de 27 mm, lesdites valeurs ayant une tolérance de +/-5 % ; et où lesdits trous N (102) ont un diamètre (D) entre 80 micromètres et 220 micromètres, tandis que lesdits points P (104) sont circulaires, avec un diamètre entre 1 mm et 4 mm.

2. Cellule photovoltaïque (10) selon la revendication précédente, **caractérisée en ce qu'**elle est associée à une couche arrière conductrice (20) ayant la couche conductrice de mise en contact (200) subdivisée en des zones carrées (201) qui sont individuellement destinées à contacter ladite cellule (10), lesdites zones carrées (201) étant au niveau de chaque cellule (10) constituant ledit panneau photovoltaïque avec une architecture à contact arrière ; et où chacune desdites zones carrées (201) est à l'intérieur subdivisée en deux portions (203-4), complémentaires l'une à l'autre, séparées pour des fins d'isolation électrique par une coupe de séparation (205), ayant une largeur constante, entre 0,5 mm et 3 mm ; ladite coupe de séparation (205) suivant un parcours qui se développe en un dessin à zigzags continu et arrondi, c'est-à-dire, sans changements abrupts de direction, de façon à s envelopper partiellement autour desdits trous N (102) et/ou lesdits points P (104) joignant pour chaque cellule (10, 100) tous les contacts électriques du même signe et excluant les autres, c'est-à-dire, réalisant une première portion N (203) destinée à joindre électriquement tous lesdits trous N (102) de la cellule (10) et y restant une deuxième portion P (204) qui est destinée à joindre électriquement tous lesdits points P (104) de la même cellule (10).

3. Cellule photovoltaïque (10) selon les revendications précédentes, **caractérisée en ce qu'**elle est associée à une couche arrière conductrice (20) comprenant lesdites zones carrées de mise en contact (201) où ladite coupe de séparation à zigzag (205) délimite des péninsules configurées comme des dents (206a-d) ayant les côtés avec un profil convergent-divergent, de façon à se rétrécir à l'extrémité, s'enveloppant partiellement autour de l'élément à contacter (102, 104), et à conduire le courant électrique avec une section non constante, c'est-à-dire, proportionnée à la quantité et à la position des éléments contactés ; et où dans ladite couche arrière conductrice (20) il y a au moins lune des configurations de mise en contact (202a-d) suivantes pour chaque zone carrée (201) de ladite face postérieure (100) de la cellule (10) :
- une première configuration (202a) est du type à peigne double avec des dents larges (206a), comme des doigts qui pénètrent l'un dans l'autre frontalement de façon complémentaire, où chaque dent de façon sélective contacte une rangée entière (103, 105) ;
- une deuxième configuration (202b) où les dents (206b) dudit peigne sont disposées orthogonalement par rapport auxdites rangées (103, 105) et où les dents centrales s'élargissent et rétrécissent de façon à comprendre deux contacts adjacents du même signe ;
- une troisième configuration (202c) où les dents (206c) sont principalement en forme de L de façon à s'adapter aux coins et/ou à l'extrémité des cordes, combinant un arrangement partiellement superposé et partiellement orthogonal par rapport auxdites rangées (103, 105), où la dent la plus courte se développe sans se plier ;
- une quatrième configuration (202d), qui est une variante alternative par rapport à ladite troisième configuration (202c), où la dent la plus courte (206d) se plie latéralement.

4. Cellule photovoltaïque (10) selon les revendications précédentes, **caractérisée en ce qu'**elle est associée à une couche arrière conductrice (20) ayant au moins 48 zones carrées de mise en contact (201) pour contacter un nombre égal desdites cellules (10), et où ladite première configuration de mise en contact (202a) est au moins égale à 70% du nombre total desdites zones carrées (201) et est présente dans toutes les cordes.

5. Cellule photovoltaïque (10) selon les revendications 1 à 4, **caractérisée en ce qu'**elle est associée à une couche arrière conductrice (20) comprenant au moins 4 zones carrées de mise en contact (201) ayant ladite deuxième configuration de mise en contact (202b).

6. Cellule photovoltaïque (10) selon au moins les revendications 1 à 4, **caractérisée en ce qu'**elle est associée à une couche arrière conductrice (20) comprenant au moins 4 zones carrées de mise en contact (201) ayant ladite troisième configuration de mise en contact (202c).

7. Cellule photovoltaïque (10) selon au moins les revendications 1 à 4, **caractérisée en ce qu'**elle est associée à une couche arrière conductrice (20) comprenant au moins 4 zones carrées de mise en contact (201) ayant ladite quatrième configuration de mise en contact (202d).

8. Cellule photovoltaïque (10) selon au moins les revendications 1 à 4, **caractérisée en ce qu'**elle est associée à une couche arrière conductrice (20) ayant 60 zones carrées de mise en contact (201) disposées en 6 rangées adjacentes ayant 10 zones carrées (201) chacune, où ladite première configuration de mise en contact (202a) est présente 44 fois, c'est-à-dire, 8 fois dans les deux rangées latérales et 7 fois dans les quatre rangées centrales ; et où ladite deuxième configuration de mise en contact (202b) est présente 4 fois dans chacune desdites rangées centrales ; et où lesdites troisième et quatrième configuration de mise en contact (202c-d) sont présentes 8 fois dans l'ensemble, c'est-à-dire, deux fois dans chaque rangée et au moins une fois à l'extrémité de façon que dans les quatre coins de ladite couche arrière conductrice (20, 200) il y a toujours au moins lune d'entre elles (202c-d).

9. Cellule photovoltaïque (10) selon au moins les revendications 1 à 4, **caractérisée en ce qu'**elle est associée à une couche arrière conductrice (20) ayant 48 zones carrées de mise en contact (201) disposées en 6 rangées adjacentes ayant 8 zones (201) chacune, où ladite première configuration de mise en contact (202a) est présente 32 fois, c'est-à-dire, 6 fois dans les deux rangées latérales et 5 fois dans les quatre rangées centrales ; et où ladite deuxième configuration de mise en contact (202b) est présente 4 fois dans chacune desdites rangées centrales ; et où lesdites troisième et quatrième configuration de mise en contact (202c-d) sont présentes 8 fois dans l'ensemble, c'est-à-dire, deux fois dans chaque rangée et au moins une fois à l'extrémité de façon que dans les quatre coins de ladite couche arrière conductrice (20, 200) il y a toujours au moins lune d'entre elles (202c-d).

10. Cellule photovoltaïque (10) selon au moins les revendications 1 à 4, **caractérisée en ce qu'**elle est associée à une couche arrière conductrice (20) ayant 72 zones carrées de mise en contact (201) disposées en 6 rangées adjacentes ayant 12 zones (201) chacune, où ladite première configuration de mise en contact (202a) est présente 56 fois, c'est-à-dire, 10 fois dans les deux rangées latérales et 9 fois dans les quatre rangées centrales ; et où ladite deuxième configuration de mise en contact (202b) est présente 4 fois dans chacune desdites rangées centrales ; et où lesdites troisième et quatrième configuration de mise en contact (202c-d) sont présentes 8 fois dans l'ensemble, c'est-à-dire, deux fois dans chaque rangée et au moins une fois à l'extrémité de façon que dans les quatre coins de ladite couche arrière conductrice (20, 200) il y a toujours au moins lune d'entre elles (202c-d).
